# EUROPÄISCHE PATENTSCHRIFT

(11) **EP 3 963 880 B1**
(45) Veröffentlichungstag und Bekanntmachung des Hinweises auf die Patenterteilung: **26.04.2023**
(21) Anmeldenummer: 20716400.5
(22) Anmeldetag: 20.03.2020
(51) Int. Cl.: H04N 9/31, B60Q 1/14, F21S 41/153

(54) **VERFAHREN ZUR STEUERUNG EINES SCHEINWERFERS EINES KRAFTFAHRZEUGS, SCHEINWERFER UND KRAFTFAHRZEUG**
METHOD FOR CONTROLLING A HEADLAMP OF A MOTOR VEHICLE, HEADLAMP AND MOTOR VEHICLE
PROCÉDÉ DE COMMANDE D'UN PHARE D'UN VÉHICULE AUTOMOBILE, PHARE ET VÉHICULE AUTOMOBILE

(30) Priorität: 29.04.2019 DE 102019111007
(43) Veröffentlichungstag der Anmeldung: 09.03.2022
(73) Patentinhaber: HELLA GmbH & Co. KGaA, 59552 Lippstadt (DE)
(72) Erfinder: HÜSTER, Christian, 33154 Salzkotten (DE); KUBITZA, Boris, 59519 Möhnesee (DE); PLÜMPE, Martin, 33181 Bad Wünnenberg (DE); VENKER, Udo, 33332 Gütersloh (DE); WILKS, Carsten, 59555 Lippstadt (DE)
(86) Internationale Anmeldenummer: PCT/EP2020/057774
(87) Internationale Veröffentlichungsnummer: WO 2020/221511

(56) Entgegenhaltungen:
- WO-A1-2018/050593
- US-A1- 2006 012 610

## Beschreibung

Die Erfindung betrifft ein Verfahren zur Steuerung eines Scheinwerfers eines Kraftfahrzeugs gemäß Anspruch 1.

Es sind Scheinwerfer bekannt, die dazu ausgebildet sind, Symbole in das Sichtfeld eines Benutzers zu projizieren. Es können beispielsweise Verkehrszeichen auf die Straße projiziert werden, sodass der Benutzer in besonderer Art auf die Verkehrszeichen aufmerksam gemacht wird.

Die WO 2018/050593 A1 offenbart eine Beleuchtungsvorrichtung für ein Kraftfahrzeug, die eine gepixelte Lichtquelle und ein optisches System umfasst, das zur Projektion eines gepixelten Lichtstrahls eingerichtet ist, der von der gepixelten Lichtquelle emittiert wird, wobei die Projektion des gepixelten Lichtstrahls auf die Straße ein Bild erzeugt.

Die US 2006/012610 A1 offenbart eine Verbesserung der Bildwiedergabe durch Sub-Pixel-Positionierung des Bildes auf der Grundlage von Pixelhomogenitätswerten.

Die US 2018/0086254 A1 offenbart ein Verfahren, mit dem der Kontrast des darzustellenden Symbols besonders stark sein soll, damit es vom Benutzer besonders gut erkannt werden kann.

Demgegenüber liegt der vorliegenden Erfindung die Aufgabe zugrunde, ein Verfahren zu schaffen bei dem das zu projizierende Symbol durch einen Benutzer noch besser erkannt werden kann. Außerdem sollen ein solcher Scheinwerfer und ein Kraftfahrzeug mit einem solchen Scheinwerfer geschaffen werden.

Diese Aufgabe wird durch ein Verfahren gemäß Anspruch 1, einen Scheinwerfer gemäß Anspruch 8 und ein Kraftfahrzeug gemäß Anspruch 9 gelöst. Ausführungsformen der Erfindung sind in den abhängigen Ansprüchen angegeben.

Der Scheinwerfer umfasst mehrere Lichtquellen. Gemäß dem Verfahren wird ein durch den Scheinwerfer zu projizierendes Projektionssymbol bestimmt. Dabei kann es sich beispielsweise um ein Straßenverkehrssymbol handeln, das einem Benutzer durch ein Schild im Straßenverkehr bekannt sein kann. Die Position und die Größe des Projektionssymbols werden bestimmt. Anschließend wird für die Lichtquellen jeweils eine erste Lichtstärke zur Projektion des Projektionssymbols an der Position mit der Größe bestimmt. Die Lichtstärke kann dabei für jede der Lichtquellen unterschiedlich sein. Es kann auch sein, dass für eine oder mehrere Lichtquellen als Lichtstärke 0 bestimmt wird.

Es wird ein erster Indikator ermittelt, der einen Hinweis darauf umfasst, wie stark sich die einzelnen ersten Lichtstärken voneinander unterscheiden. Beispielsweise kann hier ein höherer Wert bedeuten, dass sich die ersten Lichtstärken relativ stark voneinander unterscheiden.

Danach werden die Position und/oder die Größe des Projektionssymbols verändert. Mit dieser veränderten Position und/oder mit der veränderten Größe werden jeweils eine zweite Lichtstärke für die Lichtquellen zur Projektion des Projektionssymbols bestimmt. Es wird ein zweiter Indikator ermittelt, der einen Hinweis darauf umfasst, wie stark sich die einzelnen zweiten Lichtstärken voneinander unterscheiden.

Anschließend wird der erste Indikator mit dem zweiten Indikator verglichen und es wird bestimmt, ob die erste oder die zweite Lichtstärke als eine Verwendungslichtstärke verwendet wird in Abhängigkeit vom Vergleich des ersten Indikators mit dem zweiten Indikator. Mit der Verwendungslichtstärke wird dann das Projektionssymbol mit dem Scheinwerfer projiziert.

Durch die Veränderung der Position und/oder der Größe des Projektionssymbols kann unter Umständen ein stärkerer Kontrast in einzelnen Bereichen oder beim gesamten Projektionssymbol erreicht werden, da das veränderte Projektionssymbol unter Umständen besser durch die Lichtquellen dargestellt werden kann. Wenn beispielsweise ein Bildpunkt des Symbols genau durch eine Lichtquelle dargestellt werden soll, kann diese Lichtquelle genau auf die gewünschte Lichtstärke eingestellt werden. Wenn ein Bildpunkt des Symbols aber durch mehrere Lichtquellen dargestellt werden muss, da er beispielsweise aufgrund seiner Position zu einer Hälfte durch eine erste Lichtquelle und zur anderen Hälfte durch eine zweite Lichtquelle dargestellt werden muss, verringert sich der Kontrast des Projektionssymbols in diesem Bereich.

Einige Schritte des Verfahrens können auch mehrfach ausgeführt werden, sodass eine iterative Näherung an Lichtstärken erfolgen kann, mit denen das Projektionssymbol besonders gut dargestellt wird. Insbesondere die oben beschriebenen Schritte ab der Veränderung der Größe und/oder der Position können mehrfach durchgeführt werden.

Nach einer Ausführungsform der Erfindung kann das Projektionssymbol aus einem Quellsymbol, beispielsweise einem Verkehrszeichen, mit einzelnen Bildpunkten bestimmt werden. Die Bildpunkte können auch als Pixel bezeichnet werden. Es kann ein dritter Indikator ermittelt werden, der einen Hinweis darauf umfasst, wie stark sich die Helligkeiten der einzelnen Bildpunkte voneinander unterscheiden. Dann kann ein erster Unterschied zwischen dem dritten Indikator und dem ersten Indikator und ein zweiter Unterschied zwischen dem dritten Indikator und dem zweiten Indikator bestimmt werden. Die erste Lichtstärke kann dann als Verwendungslichtstärke bestimmt werden, wenn der erste Unterschied geringer als der zweite Unterschied ist. Die zweite Lichtstärke kann als Verwendungslichtstärke bestimmt werden, wenn der zweite Unterschied geringer als der erste Unterschied ist. Es kann somit die Lichtstärke verwendet werden, deren Indikator sich weniger vom dritten Indikator unterscheidet.

Nach einer Ausführungsform der Erfindung können die Lichtquellen des Scheinwerfers in Zeilen und Spalten unterteilt werden. Die Bildpunkte des Quellsymbols können ebenfalls in Zeilen und Spalten unterteilt werden. Es ist insbesondere möglich, dass die Anzahl an Zeilen und Spalten bei den Lichtquellen der Anzahl an Zeilen und Spalten bei den Bildpunkten entspricht. Sowohl für die Lichtquellen bei Verwendung der ersten Lichtstärke als auch für die Lichtquellen bei Verwendung der zweiten Lichtstärke und für die Bildpunkte kann jeweils eine Anzahl an Grenzen für jede Zeile und Spalte bestimmt. Eine Grenze kann dabei bestimmt werden, wenn ein Helligkeitsunterschied zwischen zwei benachbarten Lichtquellen beziehungsweise zwei benachbarten Bildpunkten größer ist als ein Schwellwert.

Der erste Indikator kann dann gleich der Summe aller Grenzen der Lichtquellen bei Verwendung der ersten Lichtstärken sein. Der zweite Indikator kann gleich der Summe aller Grenzen der Lichtquellen bei Verwendung der zweiten Lichtstärken sein. Der dritte Indikator kann gleich der Summe aller Grenzen der Bildpunkte sein.

Nach einer Ausführungsform der Erfindung können die Lichtquellen des Scheinwerfers in eine Anzahl an Zeilen und Spalten unterteilt werden. Die Bildpunkte des Quellsymbols können in die gleiche Anzahl an Zeilen und Spalten unterteilt werden, sodass jeder Zeile und jeder Spalte der Lichtquellen eine Spalte und eine Zeile der Bildpunkte entsprechen. Sowohl für die Lichtquellen bei Verwendung der ersten Lichtstärken als auch für die Lichtquellen bei Verwendung der zweiten Lichtstärken und für die Bildpunkte kann eine Anzahl an Grenzen für jede Zeile und jede Spalte bestimmt werden. Eine Grenze kann bei bestimmt werden, wenn ein Helligkeitsunterschied zwischen zwei benachbarten Lichtquellen beziehungsweise zwei benachbarten Bildpunkten größer ist als ein Schwellwert.

Der erste Indikator kann dabei gleich der Anzahl an Grenzen in der Spalte oder Zeile der Lichtquellen bei Verwendung der ersten Lichtstärke sein, die den größten Unterschied zu der Anzahl an Grenzen in der entsprechenden Spalte beziehungsweise Zeile der Bildpunkte aufweist. Der zweite Indikator kann gleich der Anzahl an Grenzen in der entsprechenden Spalte oder Zeile der Lichtquellen bei Verwendung der zweiten Lichtstärken sein. Der dritte Indikator kann gleich der Anzahl an Grenzen in der entsprechenden Spalte oder Zeile der Bildpunkte sein.

Nach einer Ausführungsform der Erfindung kann die erste Lichtstärke als Verwendungslichtstärke bestimmt werden, wenn die ersten Lichtstärken sich stärker voneinander unterscheiden als die zweiten Lichtstärken. Die zweite Lichtstärke kann als Verwendungslichtstärke bestimmt werden, wenn die zweiten Lichtstärken sich stärker voneinander unterscheiden als die ersten Lichtstärken.

Nach einer Ausführungsform der Erfindung kann zur Bestimmung, wie stark sich die ersten Lichtstärken voneinander unterscheiden, ein erster Mittelwert aller ersten Lichtstärken und eine erste Summe der Abweichungen der einzelnen ersten Lichtstärken von diesem ersten Mittelwert ermittelt werden. Der erste Mittelwert kann dabei insbesondere der Durchschnitt der ersten Lichtstärken sein. Zur Bestimmung, wie stark sich die zweiten Lichtstärken voneinander unterscheiden, kann ein zweiter Mittelwert aller zweiten Lichtstärken und eine zweite Summe der Abweichungen der einzelnen zweiten Lichtstärken von diesem zweiten Mittelwert ermittelt werden. Der zweite Mittelwert kann dabei insbesondere der Durchschnitt der zweiten Lichtstärken sein.

Die ersten Lichtstärken unterscheiden sich stärker voneinander als die zweiten Lichtstärken, wenn die erste Summe größer als die zweite Summe ist. Die zweiten Lichtstärken unterscheiden sich stärker voneinander als die ersten Lichtstärken, wenn die zweite Summe größer als die erste Summe ist.

Nach einer Ausführungsform der Erfindung kann im Projektionssymbol eine Anzahl an Grenzen bestimmt werden. Eine Grenze wird dabei bestimmt, wenn ein Helligkeitsunterschied zwischen zwei benachbarten Bildpunkten größer ist als ein Schwellwert. Es wird ein Bildpunktebereich bestimmt, in dem die Anzahl an Grenzen pro Bildpunkt größer ist als ein Grenzwert. Die Lichtstärke einer oder mehrerer Lichtquellen kann dann in einem dem Bildpunktebereich entsprechenden Lichtquellenbereich geändert werden.

Auf diese Weise kann in einem Bildpunktebereich mit relativ vielen Grenzen der Kontrast nochmals erhöht werden. Wenn beispielsweise ein relativ schmaler Streifen dargestellt werden soll, kann es vorteilhaft sein, die Lichtstärke einer oder mehrerer Lichtquellen zu ändern, wodurch sich die Breite des Streifens zwar verändern kann. Jedoch kann der Kontrast hierdurch unter Umständen erhöht werden. Wenn der Streifen beispielsweise eine Breite hat, die einer Lichtquelle entspricht, und er aufgrund seiner Position durch zwei Lichtquellen dargestellt werden soll, kann er unter Umständen besser durch eine einzige Lichtquelle dargestellt werden. Hierdurch können sich Verzerrungen im projizierten Symbol ergeben. Trotzdem kann das Symbol dann besser vom Benutzer erkannt werden.

Anhand der beigefügten Zeichnungen wird die Erfindung nachfolgend näher erläutert. Dabei zeigt:
- Fig. 1: zwei schematische Ansichten eines Projektionssymbols; und
- Fig. 2: ein schematisches Ablaufdiagramm eines Verfahrens nach einer Ausführungsform der Erfindung.

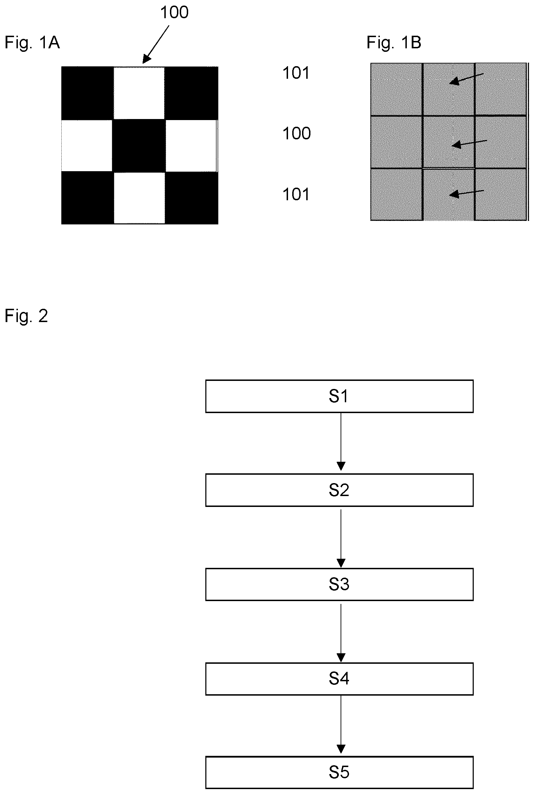

In Figur 1A ist ein Projektionssymbol mit mehreren sich abwechselnden hellen Bereichen 100 und dunklen Bereichen 101 dargestellt. Jeder helle Bereich 100 und jeder dunkle Bereich 101 entspricht dabei einem zu projizierenden Bildpunkt. Idealerweise weist das Projektionssymbol eine Position und eine Größe auf, sodass jedem Bildpunkt eine Lichtquelle des Scheinwerfers entspricht. Falls dies der Fall ist, so kann die Lichtstärke der Lichtquellen proportional zur Helligkeit des jeweiligen Bildpunkts eingestellt werden. Ein besonders großer Kontrast und eine gute Sichtbarkeit werden so erreicht.

Wenn jedoch aufgrund der Größe und/oder der Position nicht jedem Bildpunkt des Projektionssymbols auch genau eine Lichtquelle entspricht, kann das durch den Scheinwerfer projizierte Symbol wie in Figur 1B dargestellt aussehen. Dies kann der Fall sein, wenn die Bildpunkte in der horizontalen Richtung um eine halbe Bildpunktbreite relativ zu den Lichtquellen verschoben sind. In diesem Fall wird jeder Bildpunkt durch zwei Lichtquellen dargestellt. Da sich Bildpunkte mit voller Helligkeit mit dunklen Bildpunkten abwechseln, wird für jede Lichtquelle eine Lichtstärke von 50% ermittelt, sodass gar kein Kontrast mehr vorhanden und kein Symbol erkennbar ist.

Durch eine Veränderung der Position und/oder der Größe des Projektionssymbols kann somit die Sichtbarkeit des Symbols verbessert werden. Wenn beispielsweise bei einem projizierten Symbol wie in Figur 1B die horizontale Position um eine halbe Lichtquellenbreite verschoben wird, kann unter Umständen das Symbol aus Figur 1A mit sehr viel besseren Kontrasten erreicht werden.

In der Praxis wird ein Symbol wie in Figur 1A nicht durch einen Scheinwerfer projiziert werden. Das Prinzip, einen möglichst großen Kontrast zwischen hellen und dunklen Bereichen zu erreichen, bleibt jedoch auch bei anderen Symbolen bestehen, damit ein Benutzer die Symbole gut erkennen kann.

Um entscheiden zu können, bei welcher Position und Größe das Projektionssymbol besonders gut für einen Benutzer zu erkennen ist, kann beispielsweise ein Mittelwert der Lichtstärken der Lichtquellen ermittelt werden. Dieser Mittelwert ist sowohl in Figur 1A als auch in Figur 1B gleich 50%. Die Abweichungen von dem Mittelwert sind jedoch in Figur 1A sehr viel größer als in Figur 1B. Die Summe der Abweichungen vom Mittelwert ist daher ein mögliches Kriterium, um zu bestimmen, wie kontrastreich das Projektionssymbol projiziert wird.

Ein anderes Kriterium ist, das Projektionssymbol in Spalten und Zeilen einzuteilen, um dann die Anzahl an Grenzen in jeder Spalte und in jeder Zeile zu ermitteln. Unter einer Grenze wird dabei verstanden, dass die Lichtstärken zweier benachbarter Lichtquellen sich um mehr als einen Grenzwert unterscheiden. In Figur 1A weist jede Spalte und jede Zeile zwei Grenzen auf. In Figur 1B weist jede Spalte und jede Zeile hingegen keine einzige Grenze auf. Ein besonders kontrastreiches Symbol kann also auch durch eine Maximierung der Grenzen erreicht werden.

Es ist auch möglich, dass nur die Spalte oder Zeile berücksichtigt wird, bei der die Anzahl an Grenzen am meisten von der Anzahl an Grenzen in der betreffenden Spalte oder Zeile der Bildpunkte abweicht. Wenn dieser Unterschied minimiert wird, kann ebenfalls von einem besonders gut zu erkennenden Symbol ausgegangen werden.

Beim in Figur 2 dargestellten Verfahren wird zunächst in Schritt S1 ein Symbol ausgewählt, das durch den Scheinwerfer projiziert werden soll. Anschließend wird in Schritt S2 die Position, die Größe und eine Projektionsfläche festgelegt. Eine Optimierung des Kontrasts erfolgt dann in Schritt S3 wie oben beschrieben, indem die Größe und/oder die Position des Projektionssymbols verändert wird.

In einem optionalen Schritt S4 kann in einem bestimmten Bildpunktbereich noch eine weitere Optimierung erfolgen, um den Kontrast noch weiter zu verbessern. Dies kann sinnvoll sein, wenn im Symbol relativ schmale Bereiche, beispielsweise Streifen, vorhanden sind. Wenn beispielsweise ein Streifen mit einer Breite, die durch eine einzige Lichtquelle mit voller Lichtstärke dargestellt werden kann, eine Position aufweist, sodass er mit zwei Lichtquellen mit jeweils halber Lichtstärke dargestellt wird, kann es vorteilhaft sein, den Streifen mit lediglich einer der beiden Lichtquellen mit voller Lichtstärke darzustellen, obwohl dadurch die Position und/oder die Form des Streifens verändert wird. Das Ergebnis kann ein leicht verzerrtes Projektionssymbol mit verbessertem Kontrast sein. Dies ist für einen Benutzer trotz der eventuellen Verzerrung besser zu erkennen.

Im letzten Schritt S5 erfolgt dann die Projektion des Projektionssymbols mit dem wie zuvor beschrieben optimierten Kontrastverhältnissen.

### Bezugszeichenliste

- 100: Heller Bereich
- 101: Dunkler Bereich
- S1: Symbolauswahl
- S2: Festlegung Position und Größe
- S3: Optimierung des Kontrasts durch Veränderung der Position und/oder der Größe
- S4: Optionale Kontrastoptimierung
- S5: Ausgabe des Projektionssymbols durch den Scheinwerfer

## Patentansprüche

1. Verfahren zur Steuerung eines Scheinwerfers eines Kraftfahrzeugs, wobei der Scheinwerfer mehrere Lichtquellen umfasst, und wobei das Verfahren die folgenden Schritte umfasst:
- Bestimmung eines durch den Scheinwerfer zu projizierenden Projektionssymbols (S1);
- Bestimmung einer Position und einer Größe des Projektionssymbols (S2);
- Bestimmung jeweils einer ersten Lichtstärke für die Lichtquellen zur Projektion des Projektionssymbols an der Position mit der Größe (S2);
**dadurch gekennzeichnet, dass** das Verfahren weiterhin die folgenden Schritte umfasst:
- Ermittlung eines ersten Indikators, der einen Hinweis darauf umfasst, wie stark sich die einzelnen ersten Lichtstärken voneinander unterscheiden (S3); und daraufhin
- Veränderung der Position und/oder der Größe des Projektionssymbols (S3);
- Bestimmung jeweils einer zweiten Lichtstärke für die Lichtquellen zur Projektion des Projektionssymbols an der veränderten Position und/oder mit der veränderten Größe (S3); und daraufhin
- Ermittlung eines zweiten Indikators, der einen Hinweis darauf umfasst, wie stark sich die einzelnen zweiten Lichtstärken voneinander unterscheiden (S3); und daraufhin
- Vergleich des ersten Indikators mit dem zweiten Indikator (S3); und daraufhin
- Bestimmung, ob die erste oder die zweite Lichtstärke als eine Verwendungslichtstärke verwendet wird in Abhängigkeit vom Vergleich des ersten Indikators mit dem zweiten Indikator, wobei mit der Verwendungslichtstärke das Projektionssymbol mit dem Scheinwerfer projiziert wird (S5).

2. Verfahren nach Anspruch 1, wobei das Projektionssymbol aus einem Quellsymbol mit einzelnen Bildpunkten bestimmt wird, umfassend die folgenden Schritte:
- Ermittlung eines dritten Indikators, der einen Hinweis darauf umfasst, wie stark sich Helligkeiten der einzelnen Bildpunkte voneinander unterscheiden;
- Bestimmung, eines ersten Unterschieds zwischen dem dritten Indikator und dem ersten Indikator und eines zweiten Unterschieds zwischen dem dritten Indikator und dem zweiten Indikator;
- Bestimmung der ersten Lichtstärken als Verwendungslichtstärke, wenn der erste Unterschied geringer als der zweite Unterschied ist;
- Bestimmung der zweiten Lichtstärken als Verwendungslichtstärke, wenn der zweite Unterschied geringer als der erste Unterschied ist.

3. Verfahren nach dem vorherigen Anspruch, wobei die Lichtquellen des Scheinwerfers in Zeilen und Spalte unterteilt werden, und dass die Bildpunkte des Quellsymbols in Zeilen und Spalten unterteilt werden, wobei sowohl für die Lichtquellen bei Verwendung der ersten Lichtstärken als auch für die Lichtquellen bei Verwendung der zweiten Lichtstärken und für die Bildpunkte eine Anzahl an Grenzen für jede Zeile und jede Spalte bestimmt wird, wobei eine Grenze bestimmt wird, wenn ein Helligkeitsunterschied zwischen zwei benachbarten Lichtquellen beziehungsweise zwei benachbarten Bildpunkten größer ist als ein Schwellwert, wobei der erste Indikator gleich der Summe aller Grenzen der Lichtquellen bei Verwendung der ersten Lichtstärken ist, wobei der zweite Indikator gleich der Summe aller Grenzen der Lichtquellen bei Verwendung der zweiten Lichtstärken ist, und wobei der dritte Indikator gleich der Summe aller Grenzen der Bildpunkte ist.

4. Verfahren nach Anspruch 2, wobei die Lichtquellen des Scheinwerfers in eine Anzahl an Zeilen und Spalten unterteilt werden, und dass die Bildpunkte des Quellsymbols in die gleiche Anzahl an Zeilen und Spalten unterteilt werden, sodass jeder Zeile und jeder Spalte der Lichtquellen eine Spalte und eine Zeile der Bildpunkte entsprechen, wobei sowohl für die Lichtquellen bei Verwendung der ersten Lichtstärken als auch für die Lichtquellen bei Verwendung der zweiten Lichtstärken und für die Bildpunkte eine Anzahl an Grenzen für jede Zeile und jede Spalte bestimmt wird, wobei eine Grenze bestimmt wird, wenn ein Helligkeitsunterschied zwischen zwei benachbarten Lichtquellen beziehungsweise zwei benachbarten Bildpunkten größer ist als ein Schwellwert, wobei der erste Indikator gleich der Anzahl an Grenzen in der Spalte oder Zeile der Lichtquellen bei Verwendung der ersten Lichtstärken ist, die den größten Unterschied zu der Anzahl an Grenzen in der entsprechenden Spalte beziehungsweise Zeile der Bildpunkte aufweist, wobei der zweite Indikator gleich der Anzahl an Grenzen in der entsprechenden Spalte oder Zeile der Lichtquellen bei Verwendung der zweiten Lichtstärken ist, und wobei der dritte Indikator gleich der Anzahl an Grenzen in der entsprechenden Spalte oder Zeile der Bildpunkte ist.

5. Verfahren nach Anspruch 1, wobei die erste Lichtstärke als Verwendungslichtstärke bestimmt wird, wenn die ersten Lichtstärken sich stärker voneinander unterscheiden als die zweiten Lichtstärken, und dass die zweite Lichtstärke als Verwendungslichtstärke bestimmt wird, wenn die zweiten Lichtstärken sich stärker voneinander unterscheiden als die ersten Lichtstärken.

6. Verfahren nach dem vorherigen Anspruch, wobei zur Bestimmung, wie stark sich die ersten Lichtstärken voneinander unterscheiden, ein erster Mittelwert aller ersten Lichtstärken und eine erste Summe der Abweichungen von diesem ersten Mittelwert ermittelt werden, wobei zur Bestimmung, wie stark sich die zweiten Lichtstärken voneinander unterscheiden, ein zweiter Mittelwert aller zweiten Lichtstärken und eine zweite Summe der Abweichungen von diesem zweiten Mittelwert ermittelt werden, wobei die ersten Lichtstärken sich stärker voneinander unterscheiden als die zweiten Lichtstärken, wenn die erste Summe größer als die zweite Summe ist, und wobei die zweiten Lichtstärken sich stärker voneinander unterscheiden als die ersten Lichtstärken, wenn die zweite Summe größer als die erste Summe ist.

7. Verfahren nach einem der vorherigen Ansprüche, wobei im Projektionssymbol eine Anzahl an Grenzen bestimmt wird, wobei eine Grenze bestimmt wird, wenn ein Helligkeitsunterschied zwischen zwei benachbarten Bildpunkten größer ist als ein Schwellwert, wobei ein Bildpunktebereich bestimmt wird, in dem die Anzahl an Grenzen pro Bildpunkt größer ist als ein Grenzwert, wobei die Lichtstärke einer oder mehrerer Lichtquellen in einem dem Bildpunktebereich entsprechenden Lichtquellenbereich geändert wird, nachdem die Verwendungslichtstärke bestimmt worden ist (S4).

8. Scheinwerfer für ein Kraftfahrzeug, umfassend mehrere Lichtquellen und ein Steuermittel, wobei das Steuermittel dazu ausgebildet ist, ein Verfahren nach einem der vorherigen Ansprüche auszuführen.

9. Kraftfahrzeug, umfassend einen Scheinwerfer nach dem vorherigen Anspruch.

## Claims

1. Method for controlling a headlamp of a motor vehicle, where the headlamp comprises several light sources and where the method comprises the following steps:
- Determination of a projection symbol (S1) to be projected by the headlamp;
- Determination of a position and a size of the projection symbol (S2);
- Determination in each case of a first luminous intensity for the light sources for projecting the projection symbol at the position with the size (S2);
**characterized in that** the method further comprises the following steps:
- Determination of a first indicator that comprises information on how strongly the individual first luminous intensities differ from each other (S3); and then
- Change in the position and/or size of the projection symbol (S3);
- Determination in each case of a second luminous intensity for the light sources for projecting the projection symbol at the changed position and/or with the changed size (S3); and then
- Determination of a second indicator that comprises information on how strongly the individual second luminous intensities differ from each other (S3); and then
- Comparison of the first indicator with the second indicator (S3); and then
- Determination of whether the first or the second luminous intensity is deployed as the luminous intensity in use depending on the comparison between the first indicator and the second indicator where the projection symbol is projected by the headlamp at the luminous intensity in use (S5).

2. Method in accordance with Claim 1, where the projection symbol is determined from a source symbol with individual image points, comprising the following steps:
- Determination of a third indicator that comprises information on how strongly brightnesses of the individual image points differ from each other;
- Determination of a first difference between the third indicator and the first indicator and of a second difference between the third indicator and the second indicator;
- Determination of the first luminous intensities as the luminous intensity in use if the first difference is smaller than the second difference;
- Determination of the second luminous intensities as the luminous intensity in use if the second difference is smaller than the first difference.

3. Method in accordance with the previous Claim, where the light sources of the headlamp are divided into rows and columns, and in that the image points of the source symbol are divided into rows and columns, where a number of boundaries for each row and each column is determined both for the light sources when using the first luminous intensities and for the light sources when using the second luminous intensities and for the image points, where a boundary is determined if a difference in brightness between two neighbouring light sources or two neighbouring image points is larger than a threshold value, where the first indicator is equal to the total of all boundaries of the light sources when using the first luminous intensities, where the second indicator is equal to the total of all boundaries of the light sources when using the second luminous intensities and where the third indicator is equal to the total of all boundaries of the image points.

4. Method in accordance with Claim 2, where the light sources of the headlamp are divided into a number of rows and columns, and in that the image points of the source symbol are divided into the same number of rows and columns, such that one row and one column of the image points correspond to one row and one column of the light sources, where a number of boundaries for each row and each column is determined both for the light sources when using the first luminous intensities and for the light sources when using the second luminous intensities and for the image points, where a boundary is determined if a difference in brightness between two neighbouring light sources or two neighbouring image points is larger than a threshold value, where the first indicator is equal to the number of boundaries in the column or row of the light sources when using the first luminous intensities that features the largest difference to the number of boundaries in the corresponding column or row, where the second indicator is equal to the number of boundaries in the corresponding column or row of the light sources when using the second luminous intensities and where the third indicator is equal to the number of boundaries in the corresponding column or row of the image points.

5. Method in accordance with Claim 1, where the first luminous intensity is determined as the luminous intensity in use if the first luminous intensities differ more strongly from each other than the second luminous intensities and in that second luminous intensity is determined as the luminous intensity in use if the second luminous intensities differ more strongly from each other than the first luminous intensities.

6. Method in accordance with the previous Claim, where for determining how strongly the first luminous intensities differ from each other and, a first mean value of all first luminous intensities and a first sum of the deviations from this first mean value are determined, where for determining how strongly the second luminous intensities differ from each other, a second mean value of all second luminous intensities and a second sum of the deviations from this second mean value are determined, where the first luminous intensities differ more strongly from each other than the second luminous intensities if the first sum is greater than the second sum, and where the second luminous intensities differ more strongly from each other than the first luminous intensities if the second sum is greater than the first sum.

7. Method in accordance with one of the previous Claims where a number of boundaries is determined in the projection symbol, where a boundary is determined when a difference in brightness between two neighbouring image points is larger than a threshold value, where an image point area is determined in which the number of boundaries per image point is larger than a threshold value, where the luminous intensity of one or several light sources in a light source area corresponding to the image point area is changed after the luminous intensity in use has been determined (S4).

8. Headlamp for a motor vehicle comprising several light sources and a control system, where the control system is designed to perform a method in accordance with one of the previous Claims.

9. Motor vehicle comprising a headlamp in accordance with the previous Claim.

## Revendications

1. Procédé de commande d'un projecteur d'un véhicule automobile, le projecteur comprenant plusieurs sources lumineuses et le procédé comprenant les étapes suivantes :
- Détermination d'un symbole de projection (S1) à projeter par le projecteur ;
- Détermination d'une position et d'une taille du symbole de projection (S2) ;
- Détermination d'une première intensité lumineuse pour chacune des sources lumineuses utilisées pour la projection du symbole de projection à la position de la taille (S2) ;
**caractérisé en ce que** le procédé comprend en outre les étapes suivantes :
- Détermination un premier indicateur comportant une indication de la mesure dans laquelle les premières intensités lumineuses individuelles diffèrent les unes des autres (S3) ; puis
- Modification de la position et/ou de la taille du symbole de projection (S3) ;
- Détermination d'une deuxième intensité lumineuse pour chacune des sources lumineuses utilisées pour la projection du symbole de projection à la position modifiée et/ou avec la taille modifiée (S3) ; puis
- Détermination d'un second indicateur comportant une indication de l'importance de la différence entre les deuxièmes intensités lumineuses individuelles (S3) ; puis
- Comparaison du premier indicateur avec le second indicateur (S3) ; puis
- Détermination si la première ou la deuxième intensité lumineuse est utilisée comme intensité lumineuse d'utilisation en fonction de la comparaison du premier indicateur avec le second indicateur, l'intensité lumineuse d'utilisation étant utilisée pour projeter le symbole de projection avec le projecteur (S5).

2. Procédé selon la revendication 1, le symbole de projection étant déterminé à partir d'un symbole source avec des pixels individuels, comprenant les étapes suivantes :
- Détermination d'un troisième indicateur comportant une indication de la mesure dans laquelle les luminosités des pixels individuels diffèrent les unes des autres ;
- Détermination d'une première différence entre le troisième indicateur et le premier indicateur et d'une deuxième différence entre le troisième indicateur et le second indicateur ;
- Détermination des premières intensités lumineuses comme intensités lumineuses d'utilisation lorsque la première différence est inférieure à la deuxième différence ;
- Détermination des secondes intensités lumineuses en tant qu'intensité lumineuse d'utilisation lorsque la deuxième différence est inférieure à la première différence.

3. Procédé selon la revendication précédente, les sources lumineuses du projecteur étant divisées en lignes et en colonnes et les pixels du symbole source étant divisés en lignes et en colonnes, sachant qu'un nombre de limites est déterminé pour chaque ligne et chaque colonne, à la fois pour les sources lumineuses en cas d'utilisation des premières intensités lumineuses et pour les sources lumineuses en cas d'utilisation des secondes intensités lumineuses et pour les pixels, une limite étant déterminée lorsqu'une différence de luminosité entre deux sources lumineuses voisines ou deux pixels voisins est supérieure à une valeur seuil, le premier indicateur étant égal à la somme de toutes les limites des sources lumineuses en cas d'utilisation des premières intensités lumineuses, le deuxième indicateur étant égal à la somme de toutes les limites des sources lumineuses en cas d'utilisation des secondes intensités lumineuses et le troisième indicateur étant égal à la somme de toutes les limites des pixels.

4. Procédé selon la revendication 2, les sources lumineuses du projecteur étant divisées en un nombre de lignes et de colonnes et les pixels du symbole source étant divisés en un même nombre de lignes et de colonnes, de sorte qu'à chaque ligne et à chaque colonne des sources lumineuses correspondent une colonne et une ligne des pixels, sachant qu'un nombre de limites est déterminé pour chaque ligne et chaque colonne à la fois pour les sources lumineuses en cas d'utilisation des premières intensités lumineuses et pour les sources lumineuses en cas d'utilisation des secondes intensités lumineuses et pour les pixels, une limite étant déterminée, lorsqu'une différence de luminosité entre deux sources lumineuses voisines ou deux pixels voisins est supérieure à une valeur seuil, le premier indicateur étant égal au nombre de limites dans la colonne ou la ligne des sources lumineuses en cas d'utilisation des premières intensités lumineuses qui présente la plus grande différence par rapport au nombre de limites dans la colonne ou la ligne correspondante des pixels, le deuxième indicateur étant égal au nombre de limites dans la colonne ou la ligne correspondante des sources lumineuses en cas d'utilisation des secondes intensités lumineuses et le troisième indicateur étant égal au nombre de limites dans la colonne ou la ligne correspondante des pixels.

5. Procédé selon la revendication 1, la première intensité lumineuse étant déterminée comme intensité lumineuse d'utilisation lorsque les premières intensités lumineuses diffèrent davantage les unes des autres que les secondes intensités lumineuses, et la seconde intensité lumineuse étant déterminée comme intensité lumineuse d'utilisation lorsque les secondes intensités lumineuses diffèrent davantage les unes des autres que les premières intensités lumineuses.

6. Procédé selon la revendication précédente, dans lequel une première valeur moyenne de toutes les premières intensités lumineuses et une première somme des écarts par rapport à cette première valeur moyenne sont calculées afin de déterminer à quel point les premières intensités lumineuses diffèrent les unes des autres, dans lequel une deuxième valeur moyenne de toutes les deuxièmes intensités lumineuses et une deuxième somme des écarts par rapport à cette deuxième valeur moyenne sont calculées afin de déterminer à quel point les secondes intensités lumineuses diffèrent les unes des autres, les premières intensités lumineuses se distinguant davantage les unes des autres que les deuxièmes intensités lumineuses lorsque la première somme est supérieure à la deuxième somme et les secondes intensités lumineuses se distinguant davantage les unes des autres que les premières intensités lumineuses lorsque la deuxième somme est supérieure à la première somme.

7. Procédé selon l'une des revendications précédentes, dans lequel un nombre de limites est déterminé dans le symbole de projection, une limite étant déterminée lorsqu'une différence de luminosité entre deux pixels voisins est supérieure à une valeur seuil, dans lequel une zone de pixels dans laquelle le nombre de limites par pixel est supérieur à une valeur limite est déterminée, l'intensité lumineuse d'une ou plusieurs sources lumineuses étant modifiée dans une zone de sources lumineuses correspondant à la zone de pixels après avoir déterminé l'intensité lumineuse d'utilisation (S4).

8. Projecteur pour un véhicule automobile comprenant plusieurs sources lumineuses et un moyen de commande, le moyen de commande étant conçu de manière à mettre en oeuvre un procédé selon l'une des revendications précédentes.

9. Véhicule automobile comprenant un projecteur selon la revendication précédente.
